# EUROPÄISCHE PATENTSCHRIFT

(11) **EP 3 019 828 B1**
(45) Veröffentlichungstag und Bekanntmachung des Hinweises auf die Patenterteilung: **20.03.2019**
(21) Anmeldenummer: 14737237.9
(22) Anmeldetag: 08.07.2014
(51) Int. Cl.: G01D 3/02, G01D 3/08, G01R 19/257

(54) **MESSUMFORMER ZUM UMFORMEN EINES ANALOGEN ELEKTRISCHEN EINGANGSSIGNALS IN EIN ANALOGES ELEKTRISCHES AUSGANGSSIGNAL**
MEASURING TRANSDUCER FOR CONVERTING AN ANALOGUE ELECTRICAL INPUT SIGNAL INTO AN ANALOG ELECTRICAL OUTPUT SIGNAL
CONVERTISSEUR DE MESURE SERVANT À CONVERTIR UN SIGNAL ÉLECTRIQUE D'ENTRÉE ANALOGIQUE EN UN SIGNAL ÉLECTRIQUE DE SORTIE ANALOGIQUE

(30) Priorität: 09.07.2013 DE 102013107267
(43) Veröffentlichungstag der Anmeldung: 18.05.2016
(73) Patentinhaber: Phoenix Contact GmbH & Co. KG, 32825 Blomberg (DE)
(72) Erfinder: BERGMANN, Florian, 37671 Höxter (DE)
(74) Vertreter: Blumbach · Zinngrebe Patent- und Rechtsanwälte
(86) Internationale Anmeldenummer: PCT/EP2014/064623
(87) Internationale Veröffentlichungsnummer: WO 2015/004141

(56) Entgegenhaltungen:
- EP-A1- 2 597 483
- EP-A2- 0 097 479
- WO-A1-89/08819
- WO-A1-94/28632
- US-A- 4 575 806
- US-A1- 2009 303 096

## Beschreibung

Die Erfindung betrifft einen Messumformer, insbesondere einen Strom- oder Spannungsmessumformer, der ein analoges elektrisches Eingangssignal in ein analoges elektrisches Ausgangssignal umformt.

Messumformer sind hinlänglich bekannt und finden insbesondere in der Automatisierungs-, Steuerungs- und Regungstechnik Anwendung. Messumformer können beispielsweise Stromsignale oder Spannungssignale vorzugsweise in genormte Strom- bzw. Spannungssignale umwandeln und diese einem Automatisierungsgerät wie zum Beispiel einer speicherprogrammierbaren Steuerung als Eingangssignale zur Verfügung stellen. So kann ein Strommessumformer ein normiertes analoges elektrisches Stromsignal von 0 bis 20 mA liefern, während ein Spannungsmessumformer ein normiertes analoges Spannungsausgangssignal von 0 bis 10 V liefern kann. Allerdings sind auch Messumformer bekannt, die unabhängig vom Eingangssignal zwischen einem Spannungsausgang und Stromausgang umgeschaltet werden können.

Die Firma Phoenix Contact Deutschland GmbH stellt her und vertreibt Strommessumformer, bei denen ein Eingangsmessbereich, der kleiner als der maximal verwendbare Eingangsmessbereich des Strommessumformers ist, durch Eingabe einer Ober- und Untergrenze eingestellt werden kann. Der eingestellte Eingangsmessbereich, der auch als Messfenster bezeichnet wird, wird auf den maximal verfügbaren Ausgangsbereich abgebildet.

Ein Nachteil dieser Strommessumformer liegt darin, dass lediglich Messwerte innerhalb des eingestellten Messfensters hoch aufgelöst und verarbeitet werden, während alle Messinformationen, die außerhalb des eingestellten Messfensters liegen, verloren gehen.

Aus der EP 2 597 483 A1 ist ein elektrooptischer Entfernungsmesser mit einer Sendeeinheit zur Aussendung von intensitätsmodulierter optischer Strahlung und mit einer Empfangseinheit zum Empfangen eines zurückgeworfenen Anteils der optischen Strahlung und zur Umwandlung in ein elektrisches Empfangssignal bekannt. Die Empfangseinheit weist eine Konditioniereinheit auf, die das elektrische Signal konditioniert. Hierzu kann die Konditioniereinheit einen Impedanzwandler, Filter, Verstärker, Bandbegrenzer und heterodyne oder homodyne Mischer umfassen. Insbesondere weist die Konditioniereinheit eine Verstärkerstufe mit einer nichtlinearen Eingangs-Ausgangs-Charakteristik auf.

Der vorliegenden Erfindung liegt die Aufgabe zugrunde, den zuvor erwähnten Messumformer derart weiterzuentwickeln, dass die genannten Nachteile vermieden werden.

Ein Kerngedanke der Erfindung kann darin gesehen werden, einen Messumformer zu schaffen, der zum Beispiel in Abhängigkeit von der Bedeutung wenigstens einer in einem Prozess benötigten Messgröße analoge elektrische Eingangssignale, die innerhalb des maximal zulässigen Eingangsmessbereich empfangen werden, mit einstellbaren, unterschiedlichen Auflösungen in analoge, elektrische Ausgangssignale umformt, die innerhalb des maximal zulässigen Ausgangsbereich des Messumformers liegen.

Das oben genannte technische Problem kann durch die Merkmale des Anspruchs 1 gelöst werden.

Danach ist ein Messumformer zum Umformen eines analogen elektrischen Eingangssignals in ein analoges elektrisches Ausgangssignal vorgesehen. Der Messumformer kann eine Erfassungseinrichtung aufweisen, die dazu ausgebildet ist, ein analoges elektrisches Eingangssignal innerhalb eines vorbestimmten Eingangsmessbereichs zu erfassen. Der Eingangsmessbereich des Messumformers ist in n einstellbare Eingangsteilmessbereiche unterteilt, während der Ausgangsbereichs des Messumformers in n einstellbare Ausgangsteilmessbereiche unterteilt ist, wobei n größer als 1 ist. Ferner kann im Messumformer eine Einrichtung implementiert sein, die dazu ausgebildet ist, den Eingangsteilmessbereich, in welchem das erfasste analoge elektrische Eingangssignal liegt, zu erkennen. Weiterhin kann im Messumformer eine Abbildungseinrichtung vorgesehen sein, die dazu ausgebildet ist, jeden Eingangsteilmessbereich auf einen separaten Ausgangsteilbereich der in Ausgangsteilbereiche abzubilden. Der Messumformer kann weiterhin eine Einrichtung aufweisen, die dazu ausgebildet ist, das erfasste analoge elektrische Eingangssignal in Abhängigkeit vom erkannten Eingangsteilmessbereich in das dazugehörende analoge elektrische Ausgangssignal umzuformen.

Bei dem vorbestimmten Eingangsmessbereich handelt es sich vorzugsweise um den vom Messumformer maximal nutzbaren Eingangsmessbereich.

In Abhängigkeit von der Bedeutung oder Wichtigkeit wenigstens einer zu messenden physikalischen Größe kann jeder Eingangsteilmessbereich in gestauchter oder gespreizter Form auf den jeweiligen Ausgangsteilbereich abgebildet werden. In "gestauchter Form abgebildet" bedeutet, dass Eingangssignale, die innerhalb des jeweiligen Eingangsteilmessbereichs liegen, mit einer niedrigeren Auflösung in ein Ausgangssignal umgeformt werden, als Eingangssignale, die innerhalb eines Eingangsteilmessbereichs liegen, der "in gespreizter Form" auf den dazugehörenden Ausgangsteilbereich abgebildet werden.

Vorzugsweise kann der Messumformer als Strom- oder Spannungsmessumformer ausgebildet sein, der einen analogen Eingangsstrom in einen analogen Ausgangsstrom bzw. eine analoge Eingangsspannung in eine analoge Ausgangsspannung umformt.

Das oben genannte technische Problem kann ferner durch die Verfahrensschritte des Anspruchs 4 gelöst werden.

Danach wird ein Verfahren zum Umformen eines analogen elektrischen Eingangssignals in ein analoges elektrisches Ausgangssignal zur Verfügung gestellt. Das Verfahren sieht vorzugsweise vor, dass ein an einem Messumformer anliegendes analoges, elektrisches Eingangssignal innerhalb eines vorbestimmten Eingangsmessbereichs erfasst wird. Der Eingangsmessbereich des Messumformers wird in n einstellbarer Eingangsteilmessbereiche unterteilt, während der Ausgangsbereich des Umformers n einstellbarer Ausgangsteilbereiche unterteilt wird. Hierbei wird n größer als 1 gewählt. Jeder Eingangsteilmessbereich kann auf einen separaten Ausgangsteilbereich der n Ausgangsteilbereiche abgebildet werden.

Das erfasste analoge elektrische Eingangssignal kann dem Eingangsteilmessbereich, in welchem das Eingangssignal liegt, zugeordnet werden. Das erfasste analoge elektrische Eingangssignal wird in das dazugehörende analoge elektrische Ausgangssignal in Abhängigkeit von dem dem Eingangssignal zugeordneten Eingangsteilmessbereich umgeformt.

Jeder Eingangsteilmessbereich kann durch Eingeben eines Ober- und Untergrenzwertes definiert werden. In ähnlicher Weise kann jeder Ausgangsteilbereich durch Eingeben eines Ober- und Untergrenzwertes definiert werden.

Die Erfindung wird nachfolgend anhand eines Ausführungsbeispiels in Verbindung mit den Zeichnungen näher erläutert. Es zeigen:
- Fig. 1: einen beispielhaften Strommessumformer gemäß der Erfindung, der mit einer speicherprogrammierbaren Steuerung verbunden ist, und
- Fig. 2: in graphischer Darstellung die von dem in Fig. 1 gezeigten Messumformer angewandten Abbildungsvorschriften.

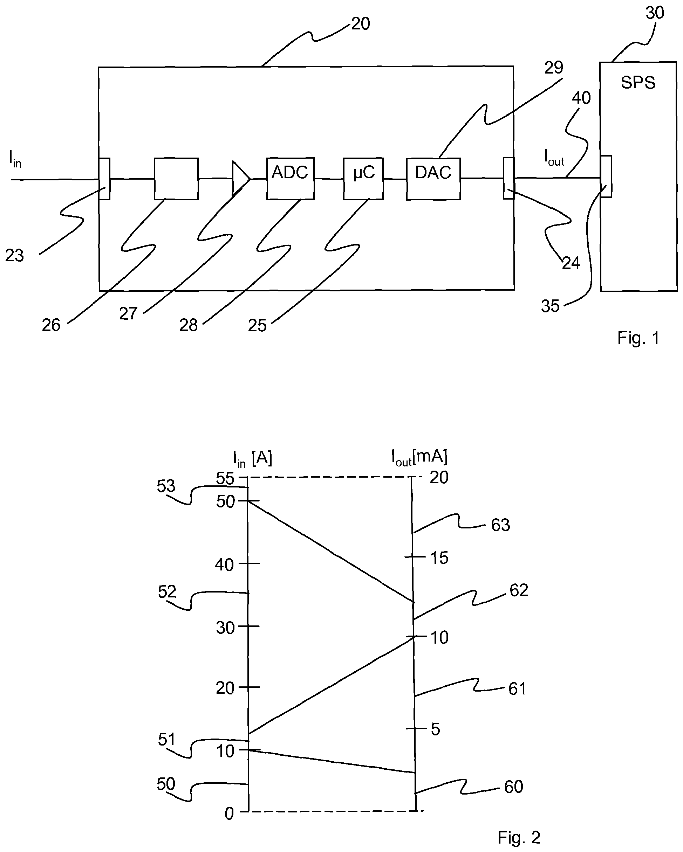

Fig. 1 zeigt ausschnittsweise ein beispielhaftes Automatisierungssystem 10 mit einem Automatisierungsgerät 30, welches als speicherprogrammierbare Steuerung, kurz SPS genannt, ausgebildet sein kann. Die speicherprogrammierbare Steuerung 30 enthält beispielsweise eine analoge Eingangsschnittstelle 35, an die, wie Fig. 1 zeigt, ein Messumformer 20 angeschlossen sein kann. Selbstverständlich kann die SPS 30 in an sich bekannter Weise mehrere analoge und digitale Eingangsschnittstellen sowie analoge und digitale Ausgangsschnittstellen (nicht dargestellt) aufweisen. Der Messumformer 20 kann zum Beispiel ein Strom- und/oder Spannungsmessumformer sein. Nachfolgend wird lediglich beispielhaft ein Strommessumformer betrachtet.

Beim erläuterten Bespiel handelt es sich bei der analogen Eingangsschnittstelle 35 vorzugsweise um eine standardisierte analoge Eingangsstromschnittstelle, die vorzugsweise einen analogen Eingangsstrom von 0 bis 20mA aufnehmen kann, der beispielsweise vom Messumformer 20 über eine analoge Ausgangsschnittstelle 24 und über eine Leitung 40 der SPS 30 zugeführt wird. Anstelle eines analogen Eingangsstroms könnte auch eine analoge Eingangsspannung verwendet werden.

In an sich bekannter Weise kann der Strommessumformer 20 eine Erfassungseinrichtung 26 aufweisen, die einen an einer analogen Eingangsschnittstelle 23 ankommenden analogen Eingangsstrom I_{IN} erfassen, d. h. messen kann. Der Messumformer 20 ist beispielsweise dazu ausgebildet, analoge Eingangsströme zwischen 0 und 55A zu verarbeiten. Demzufolge reicht der maximal nutzbare Eingangsmessbereich des Messumformers 20 von 0 bis 55A. Der Erfassungseinrichtung 26 können ein Verstärker 27 und ein AD-Wandler 28 nachgeschaltet sein, der den vom Verstärker 27 gelieferten analogen Eingangsstrom in ein Digitalsignal umwandelt. Das Digitalsignal kann einer digitalen Verarbeitungseinheit 25 zugeführt werden, die als Mikrokontroller oder programmierbarer Mikroprozessor ausgebildet sein kann. Das Ausgangssignal der Verarbeitungseinheit 25 kann einem DA-Wandler 29 übergeben werden, der ausgangsseitig einen analogen Ausgangsstrom I_{OUT} der Ausgangsschnittstelle 24 zuführt. Der analoge Ausgangsstrom I_{OUT} entspricht dem umgeformten analogen Eingangsstrom I_{IN}.

Die Verarbeitungseinheit 25 ist vorzugsweise dazu ausgebildet, das digitale Ausgangssignal des AD-Wandlers 28, der dem analogen Eingangsstrom I_{IN} entspricht, in Abhängigkeit von dessen Größe unter Anwendung einer Abbildungsvorschrift, die aus mehreren verschiedenen Abbildungsvorschriften ausgewählt werden kann, mit Hilfe des DA-Wandlers 29 in den entsprechenden analogen Ausgangsstrom I_{OUT} umzuformen.

Abbildungsvorschriften werden vorzugsweise definiert, indem der für den Strommessumformer 20 definierte maximale Eingangsmessbereich, der beispielhaft von 0 bis 55A reicht, in n einstellbare Eingangsteilmessbereiche und der definierte Ausgangsbereich des Strommessumformers 20, der beispielsweise von 0 bis 20 mA reicht, in n einstellbare Ausgangsteilbereiche unterteilt wird.

Wie in Fig. 2 lediglich beispielhaft dargestellt, wurde der Eingangsmessbereich des Strommessumformers 20 in vier Eingangsteilmessbereiche 50 bis 53 und der Ausgangsbereich in vier Ausgangsteilbereiche 60 bis 63 unterteilt. Beispielsweise erfasst der erste Eingangsteilmessbereich 50 analoge Eingangsströme von 0 bis 10A, der zweite Eingangsteilmessbereich 51 analoge Eingangsströme von 10A bis 12A, der dritte Eingangsteilmessbereich 52 analoge Eingangsströme von 12A bis 50A, und der vierte Eingangsteilmessbereich 53 analoge Eingangsströme von 50A bis 55A. In ähnlicher Weise erfasst der erste Ausgangsteilbereich 60 beispielsweise analoge Ausgangsströme von 0 bis 2mA, der zweite Ausgangseilbereich 61 analoge Ausgangsströme von 2mA bis 10mA, der dritte Ausgangsteilbereich 62 analoge Ausgangsströme von 10mA bis 12mA, und der vierte Ausgangsteilbereich 63 analoge Ausgangsströme von 12mA bis 20mA.

Entsprechend dieser beispielhaft gewählten Unterteilung wird der erste Eingangsteilmessbereich 50 in gestauchter Form auf den ersten Ausgangsteilbereich 60, der zweite Eingangsteilmessbereich 51 in gespreizter Form auf den zweiten Ausgangsteilbereich 61, der dritte Eingangsteilmessbereich 52 in gestauchter Form auf den dritten Ausgangsteilbereich 62 und der vierte Eingangsteilmessbereich 53 in gespreizter Form auf den vierten Ausgangsteilbereich 63 mittels der Verarbeitungseinheit 25 abgebildet. Diese Abbildungsfunktion kann von der Verarbeitungseinheit 25 ausgeführt werden. Insoweit führt die Verarbeitungsfunktion 25 die Funktion einer Abbildungseinrichtung aus, die beim erläuterten Beispiel insbesondere geeignet ist, jeden der vier Eingangsteilmessbereiche auf einen separaten Ausgangsteilbereich der vier Ausgangsteilbereiche abzubilden. Die Abbildungseinrichtung ist vornehmlich als Software realisiert.

Aufgespreizte Abbildungsvorschriften bedeuten, dass Eingangsströme I_{IN}, die in den zweiten oder vierten Eingangsteilmessbereich fallen, höher aufgelöst werden, als Eingangsströme I_{IN}, die in den ersten oder dritten Eingangsteilmessbereich fallen, welche gestauchten Abbildungsvorschriften zugeordnet sind. In anderen Worten gesprochen, können dank des erläuterten beispielhaften Strommessumformer 20 Eingangsströme, die in den zweiten oder vierten Eingangsteilmessbereich fallen, genauer von der SPS 30 überwacht werden, als Eingangsströme, die in den ersten oder dritten Eingangsteilmessbereich fallen.

Die vier Abbildungsvorschriften, welche schematisch in Fig. 2 dargestellt sind, können dadurch definiert werden, dass am Messumformer 20 für jeden Eingangsteilmessbereich die jeweilige Ober- und Untergrenze und für jeden Ausgangsteilbereich ebenfalls die jeweilige Ober- und Untergrenze eingegeben werden.

Die Anzahl der Eingangsteilmessbereiche und Ausgangsteilbereiche sowie deren jeweilige Bereichsweite können in Abhängigkeit von Systemanforderungen und/oder der Wichtigkeit zu überwachender physikalischer Größen, wie zum Beispiel Motorenströme, festgelegt werden. In jedem Fall gibt es wenigstens zwei Eingangsteilmessbereiche und zwei Ausgangsteilbereiche.

Die in Fig. 2 gezeigten Abbildungsvorschriften können beispielsweise in einem Speicher (nicht dargestellt) als Nachschlagetabelle hinterlegt sein, auf die die Verarbeitungseinheit 25 zugreifen kann. Denkbar ist auch, dass die Verarbeitungseinheit 25 derart programmiert wird, dass sie die Abbildungsvorschriften entsprechend der nachfolgenden Gleichungen berechnen kann:
1. Abbildungsvorschrift:

| | |
|---|---|
| 0≤I_{IN}≤10A | I_{OUT}=I_{IN} x 2mA/10A |

2. Abbildungsvorschrift:

| | |
|---|---|
| 10A≤I_{IN}≤12A | I_{OUT}= (I_{IN}-10A) 8mA/(12A-10A)+2mA |

3. Abbildungsvorschrift:

| | |
|---|---|
| 12A≤I_{IN}≤50A | I_{OUT}= (I_{IN}-12A) 2mA/(50A-12A)+10mA |

4. Abbildungsvorschrift:

| | |
|---|---|
| 50A≤I_{IN}≤55A | I_{OUT}= (I_{IN}-50A) 8mA/(55A-50A)+12mA |

Die Verarbeitungseinheit 25 kann weiterhin die Funktion einer Einrichtung übernehmen, die dazu ausgebildet ist, den Eingangsteilmessbereich, in welchem ein erfasstes analoges elektrisches Eingangssignal liegt, zu erkennen. Die Verarbeitungseinheit 25 kann zusammen mit dem DA-Wandler 29 die Funktion einer Einrichtung übernehmen, die dazu ausgebildet ist, dass erfasste analoge elektrische Eingangssignal in Abhängigkeit vom erkannten Eingangsteilmessbereich in das dazugehörende analoge elektrische Ausgangssignal umzuformen, indem die Verarbeitungseinheit 25 die zum erkannten Eingangsteilmessbereich gehörende Abbildungsvorschrift anwendet. Das Ausgangssignal der Verarbeitungseinheit 25 ist dann ein Digitalwert, welches vom DA-Wandler 29 in das analoge elektrische Ausgangssignal I_{OUT} umgewandelt und zur Übertragung an die SPS 30 an den Ausgang 24 des Messumformers 20 anlegt wird.

Nachfolgend wird die Funktionsweise des beispielhaften Automatisierungssystems 10 näher erläutert.

Angenommen sei, dass die SPS 30 den ordnungsgemäßen Betrieb eines sicherheitsrelevanten Motors (nicht dargestellt), der beispielsweise 11 A verbraucht, präzise überwachen soll.

Dank des beispielhaft erläuterten Strommessumformers 20 können analoge Eingangsströme, die zwischen 10A und 12A und somit im zweiten Eingangsteilmessbereich 51 liegen, gegenüber einem herkömmlichen Strommessumformer mit höherer Auflösung und einem niedrigeren Fehler verarbeitet werden.

Angenommen sei nunmehr, dass ein analoger Motorstrom von 11A an der analogen Eingangsschnittstelle 23 anliegt. Der Motorstrom wird von der Erfassungseinrichtung 26 erfasst bzw. gemessen, im Verstärker geeignet verstärkt und im AD-Wandler 28 in ein Digitalsignal, das dem analogen Motorsignal entspricht, umgewandelt. Unter Ansprechen auf das Digitalsignal erkennt die Verarbeitungseinheit 25, dass der analoge Motorstrom in den zweiten Eingangsteilmessbereich 51 fällt und deshalb auf den zweiten Ausgangsteilbereich 61 abzubilden ist. Unter Anwendung der entsprechenden Abbildungsvorschrift erzeugt die Verarbeitungseinheit 25 am Ausgang ein Digitalsignal, welches einem analogen Ausgangsstrom von 6mA entspricht, der zum Eingangsstrom von 11A gehört. Das Digitalsignal wird anschließend vom DA-Wandler 29 in den analogen Ausgangsstrom von 6mA umgewandelt und zur SPS 30 zur weiteren Verarbeitung übertragen.

Sei angenommen, dass die Erfassungseinrichtung 26 und der AD-Wandler 28 eine Ungenauigkeit von kleiner als 0,1%, die Verarbeitungseinheit 25 und der DA-Wandler 29 eine Ungenauigkeit von kleiner als 0,5%, die Übertragungsstrecke 40 einen Fehler von 2% und die SPS 30 eine Eingangsungenauigkeit von 1% aufweisen, dann beträgt der Messfehler hinsichtlich des zweiten Eingangsteilmessbereichs 51 lediglich etwa 0,2A gegenüber einem Messfehler von etwa 2A bei einem herkömmlichen Strommessumformer. Das bedeutet, dass mit Hilfe des beispielhaft erläuterten Strommessumformers 30 der Motorstrom deutlich genauer überwacht werden kann, als dies mit herkömmlichen Strommessumformern, die keinen unterteilten Ausgangsbereich aufweisen, der Fall ist.

Der Messumformer 30 kann auch als Spannungsmessumformer betrieben werden. In diesem Fall kann die Erfassungseinrichtung 26 dazu ausgebildet, eine analoge Spannung zu messen, während die Verarbeitungseinheit 25 unter Anderem dazu ausgebildet sein kann, digitale Signale, die analogen Eingangsspannungen entsprechen, unter Anwendung vorbestimmter Abbildungsvorschriften zusammen mit dem DA-Wandler 29 in dazugehörende analoge Ausgangsspannungen umzusetzen.

## Patentansprüche

1. Messumformer (30) zum Umformen eines analogen elektrischen Eingangssignals in ein analoges elektrisches Ausgangssignal mit
einer Erfassungseinrichtung (26), die dazu ausgebildet ist, ein analoges elektrisches Eingangssignal innerhalb eines vorbestimmten Eingangsmessbereichs zu messen, wobei der Eingangsmessbereich des Messumformers in n einstellbare Eingangsteilmessbereiche (50-53) und der definierte Ausgangsbereich des Messumformers in n einstellbare Ausgangsteilbereiche (60-63) unterteilt ist, wobei am Messumformer (30) für jeden Eingangsteilmessbereich und für jeden Ausgangsteilmessbereich eine Ober- und Untergrenze eingebbar ist, die jeweils eine Abbildungsvorschrift definieren, wobei n größer als 1 ist,
einem Verstärker (27) und einem AD-Wandler (28), die der Erfassungseinrichtung (26) nachgeschaltet sind, einer dem AD-Wandler (28) nachgeschalteten digitalen Verarbeitungseinrichtung (25), die dazu ausgebildet ist, den Eingangsteilmessbereich, in welchem das gemessene analoge elektrische Eingangssignal liegt, zu erkennen, und den erkannten Eingangsteilmessbereich auf einen der n Ausgangsteilbereiche in Abhängigkeit der entsprechenden Abbildungsvorschrift abzubilden, und
einem der digitalen Verarbeitungseinrichtung (25) nachgeschalteten DA-Wandler (29), wobei die digitale Verarbeitungseinrichtung (25) und der nachgeschaltete DA-Wandler (29) eine Einrichtung (25, 29) bilden, die dazu ausgebildet ist, das gemessene analoge elektrische Eingangssignal in Abhängigkeit vom erkannten Eingangsteilmessbereich in das dazugehörende analoge elektrische Ausgangssignal umzuformen, indem die digitale Verarbeitungseinrichtung (25) die zum erkannten Eingangsteilmessbereich gehörende Abbildungsvorschrift anwendet und ein digitales Ausgangssignal dem DA-Wandler (29) zuführt, und indem der DA-Wandler (29) das digitale Ausgangssignal der digitalen Verarbeitungseinrichtung (25) in das analoge elektrische Ausgangssignal umwandelt, wobei jeder Eingangsteilmessbereich in gestauchter oder gespreizter Form auf den jeweiligen Ausgangsteilbereich abgebildet ist, wobei wenigstens einer der Eingangsteilmessbereiche in gestauchter Form auf den jeweiligen Ausgangsteilbereich abgebildet ist, und wobei wenigstens ein anderer der Eingangsteilmessbereiche in gespreizter Form auf den jeweiligen Ausgangsteilbereich abgebildet ist.

2. Messumformer nach Anspruch 1,
**dadurch gekennzeichnet, dass**
der Messumformer als Strom- oder Spannungsmessumformer ausgebildet ist.

3. Messumformer nach Anspruch 1 oder 2,
**dadurch gekennzeichnet, dass**
die Abbildungsvorschriften in einem Speicher als Nachschlagetabelle hinterlegt sind, auf die die digitale Verarbeitungseinrichtung (25) zugreifen kann.

4. Messumformer nach Anspruch 1 oder 2,
**dadurch gekennzeichnet, dass**
die digitale Verarbeitungseinrichtung (25) derart programmiert ist, dass sie die Abbildungsvorschriften berechnen kann.

5. Messumformer nach einem der vorstehenden Ansprüche,
**gekennzeichnet durch**
einen mit dem D/A-Wandler (29) verbundene analoge Ausgangsschnittstelle (24), die zum Anschließen an eine standardisierte analoge Eingangsschnittstelle (35) eines Automatisierungsgeräts (30) ausgebildet ist.

## Claims

1. A measuring transducer (30) for converting an analog electrical input signal into an analog electrical output signal, comprising
a detection device (26) adapted to measure an analog electrical input signal within a predetermined input measurement range, wherein the input measurement range of the measuring transducer is divided into n adjustable partial input measurement ranges (50 - 53) and the defined output range of the measuring transducer is divided into n adjustable partial output ranges (60 - 63), wherein an upper limit and a lower limit can be entered at the measuring transducer (30) for each partial input measurement range and for each partial output measurement range, which each define a mapping rule, wherein n is greater than 1;
an amplifier (27) and an A/D converter (28) which are connected downstream of the detection device (26);
a digital processing device (25) connected downstream of the A/D converter (28) and adapted to identify the partial input measurement range in which the measured analog electrical input signal is included, and to map the identified partial input measurement range to one of the n partial output ranges on the basis of the respective mapping rule; and
a D/A converter (29) connected downstream of the digital processing device (25), wherein the digital processing device (25) and the downstream connected D/A converter (29) form a device (25, 29) which is adapted to convert the measured analog electrical input signal into the associated analog electrical output signal in response to the identified partial input measurement range, by having the digital processing device (25) applying the mapping rule associated with the identified partial input measurement range and supplying a digital output signal to the D/A converter (29), and by having the D/A converter (29) converting the digital output signal from the digital processing device (25) into the analog electrical output signal, wherein each partial input measurement range is mapped to the respective partial output range in compressed or spread form, wherein at least one of the partial input measurement ranges is mapped to the respective partial output range in compressed form, and wherein at least one other of the partial input measurement ranges is mapped to the respective partial output range in spread form.

2. The measuring transducer according to claim 1, **characterized in that** the measuring transducer is configured as a current measuring transducer or as a voltage measuring transducer.

3. The measuring transducer according to claim 1 or 2, **characterized in that** the mapping rules are stored in a memory as a look-up table which is accessible by the digital processing device (25).

4. The measuring transducer according to claim 1 or 2, **characterized in that** the digital processing device (25) is programmed so as to be able to calculate the mapping rules.

5. The measuring transducer according to any one of the preceding claims, **characterized by**
an analog output interface (24) connected to the D/A converter (29) and adapted for being connected to a standardized analog input interface (35) of an automation device (30).

## Revendications

1. Convertisseur de mesure (30) destiné à convertir un signal d'entrée électrique analogique en signal de sortie électrique analogique, comprenant :
un dispositif d'acquisition (26), qui est conçu de façon à mesurer un signal d'entrée électrique analogique à l'intérieur d'une plage de mesure d'entrée prédéfinie, où la plage de mesure d'entrée du convertisseur de mesure est subdivisée en n parties de plage de mesure d'entrée (50-53) réglables et la plage de sortie définie du convertisseur de mesure est subdivisée en n parties de plage de sortie (60-63) réglables, où une limite supérieure et une limite inférieure, qui définissent chacune une règle de mappage, peuvent être entrées sur le convertisseur de mesure (30) pour chaque partie de plage de mesure d'entrée et pour chaque partie de plage de mesure de sortie, où n est supérieur à 1,
un amplificateur (27) et un convertisseur analogique-numérique (28), qui sont montés en aval du dispositif d'acquisition (26),
un dispositif de traitement numérique (25) qui est monté en aval du convertisseur analogique-numérique (28) et qui est conçu de façon à identifier la partie de plage de mesure d'entrée dans laquelle le signal d'entrée électrique analogique mesurée se situe, et à mapper la partie de plage de mesure d'entrée identifiée sur une des n parties de plage de sortie en fonction de la règle de mappage correspondante, et
un convertisseur numérique-analogique (29) monté en aval du dispositif de traitement numérique (25), où le dispositif de traitement numérique (25) et le convertisseur numérique-analogique (29) monté en aval forment un dispositif (25, 29) qui est conçu de façon à convertir le signal d'entrée électrique analogique mesurée en signal de sortie électrique analogique correspondant en fonction de la partie de plage de mesure d'entrée identifiée, par le fait que le dispositif de traitement numérique (25) applique la règle de mappage faisant partie de la partie de plage de mesure d'entrée identifiée et amène un signal de sortie numérique au convertisseur numérique-analogique (29), et par le fait que le convertisseur numérique-analogique (29) convertit le signal de sortie numérique du dispositif de traitement numérique (25) en signal de sortie électrique analogique, où chaque partie de plage de mesure d'entrée est représentée sous forme comprimée ou étendue sur la partie de plage de sortie respective, où au moins une des parties de plage de mesure d'entrée est mappée sous forme comprimée sur la partie de plage de sortie respective, et où au moins une autre des parties de plage de mesure d'entrée est mappée sous forme étendue sur la partie de plage de sortie respective.

2. Convertisseur de mesure selon la revendication 1, **caractérisé en ce que** le convertisseur de mesure est réalisé sous la forme d'un convertisseur de mesure de courant ou de tension.

3. Convertisseur de mesure selon la revendication 1 ou 2, **caractérisé en ce que** les règles de mappage sont enregistrées dans une mémoire sous forme de table de consultation à laquelle le dispositif de traitement numérique (25) peut accéder.

4. Convertisseur de mesure selon la revendication 1 ou 2, **caractérisé en ce que** le dispositif de traitement numérique (25) est programmé de manière à pouvoir calculer les règles de mappage.

5. Convertisseur de mesure selon l'une quelconque des revendications précédentes, **caractérisé par** une interface de sortie analogique (24) connectée au convertisseur numérique-analogique (29), laquelle est conçue pour être raccordée à une interface d'entrée analogique (35) standardisée d'un appareil d'automatisation (30).
